# EUROPEAN PATENT APPLICATION

(11) **EP 4 783 804 A1**
(43) Date of publication of application: **29.07.2026**
(21) Application number: 24868804.6
(22) Date of filing: 19.09.2024
(51) Int. Cl.: H10K 59/80, H10K 59/38, H10K 59/122, H10K 59/40, H10K 59/12

(54) **DISPLAY DEVICE**

(30) Priority: 19.09.2023 KR 20230124997
(71) Applicant: Samsung Display Co., Ltd., Yongin-si, Gyeonggi-do 17113 (KR)
(72) Inventor: KIM, Sujeong, Yongin-si Gyeonggi-do 17113 (KR); KIM, Wooyoung, Yongin-si Gyeonggi-do 17113 (KR); LEE, Jungwoo, Yongin-si Gyeonggi-do 17113 (KR); LEE, Jinhyeong, Yongin-si Gyeonggi-do 17113 (KR)
(74) Representative: Gulde & Partner
(86) International application number: PCT/KR2024/096209
(87) International publication number: WO 2025/063831

(57) **Abstract**

Provided in one embodiment of the present invention is a display device comprising: a substrate: a pixel definition film which is arranged on the substrate, and in which a first opening is defined; a first organic light-emitting diode which is arranged in the first opening, and which includes a pixel electrode, a light-emitting layer and an opposing electrode; a first light blocking layer which is arranged on the pixel definition film, and in which a second opening overlapping the first opening is defined; a first color filter arranged to overlap the second opening; and a first high refractive layer which overlaps the first light blocking layer, and which has convex lens shape.

## Description

### Technical Field

One or more embodiments are directed to a display apparatus.

### Background Art

Organic light-emitting display apparatuses are self-emitting, and unlike liquid crystal display apparatuses, do not require separate light sources, thereby having reduced thicknesses and weight. In addition, organic light-emitting display apparatuses have characteristics such as low power consumption, high luminance, and fast response time.

### Disclosure of Invention

### Technical Problem

One or more embodiments include a display apparatus with increased visibility and quality. However, embodiments are examples, and do not necessarily limit the scope of the present disclosure.

### Solution to Problem

According to one or more embodiments, a display apparatus includes a substrate, a pixel-defining film disposed on the substrate and including a first opening formed therein, a first organic light-emitting diode that includes a pixel electrode, an emission layer, and a counter electrode disposed in the first opening, a first light-blocking layer disposed on the pixel-defining film and that includes a second opening formed therein, where the second opening overlaps the first opening, a first color filter that overlaps the second opening, and a first high-refractive index layer that overlaps the first light-blocking layer and has a convex lens shape.

The display apparatus may further include a first touch electrode disposed on the first organic light-emitting diode, where the first light-blocking layer overlaps the first touch electrode.

The first touch electrode may include at least one of titanium (Ti), aluminum (Al), molybdenum (Mo), or copper (Cu).

The display apparatus may further include an overcoat layer disposed on the first high-refractive index layer.

A refractive index of the first high-refractive index layer may be greater than a refractive index of the overcoat layer.

A size of the second opening may be greater than a size of the first opening.

A length of the first high-refractive index layer in a first direction may be greater than a length of the first light-blocking layer in the first direction.

The display apparatus may further include a thin-film encapsulation layer disposed on the first organic light-emitting diode.

The display apparatus may further include a touchscreen layer disposed on the thin-film encapsulation layer.

The display apparatus may further include a pixel circuit disposed on the substrate and electrically connected to the first organic light-emitting diode.

The display apparatus may further include a second light-blocking layer that overlaps at least a part of the first organic light-emitting diode.

The display apparatus may further include a second high-refractive index layer that overlaps the second light-blocking layer and has a convex lens shape.

A length of the second light-blocking layer in a first direction may be less than a length of the first opening in the first direction.

The display apparatus may further include a second touch electrode disposed in the second light-blocking layer.

A length of the second high-refractive index layer in a first direction may be greater than a length of the second light-blocking layer in the first direction.

The second touch electrode may include at least one of titanium (Ti), aluminum (Al), molybdenum (Mo), or copper (Cu).

According to one or more embodiments, a display apparatus includes a first sub-pixel and a second sub-pixel disposed in a display area, a light-blocking layer that overlaps an emission area of the first sub-pixel and includes an opening portion, a first color filter layer that overlaps the emission area of the first sub-pixel, and a high-refractive index layer disposed on the first color filter layer and that overlaps the light-blocking layer and has a convex lens shape.

The display apparatus may further include a first touch electrode, where the first touch electrode does not overlap the emission area of the first sub-pixel and directly contacts the light-blocking layer.

The display apparatus may further include a metal light-blocking portion, where the metal light-blocking portion overlaps the emission area of the first sub-pixel and directly contacts the light-blocking layer.

The first touch electrode may transmit a touch signal, and the metal light-blocking portion may be grounded.

### Advantageous Effects of Invention

According to embodiments described above, a display apparatus with increased visibility and quality can be realized. However, a scope of embodiments of the present disclosure is not necessarily limited by this effect.

### Brief Description of Drawings

FIG. 1 is a plan view of a display apparatus, according to an embodiment.
FIGS. 2 to 4 are cross-sectional views of a part of a display apparatus, according to an embodiment.
FIG. 5 illustrates a display element provided in one sub-pixel of a display apparatus and a pixel circuit connected to the display element, according to an embodiment.
FIG. 6 is a cross-sectional view of a display apparatus, according to an embodiment.
FIGS. 7 to 9 are cross-sectional views of a display apparatus, according to an embodiment.

### Mode for the Invention

Reference will now be made in detail to embodiments, examples of which are illustrated in the accompanying drawings, wherein like reference numerals may refer to like elements throughout. As used herein, the term "A and/or B" indicates only A, only B, or A and B. Throughout the disclosure, the expression "at least one of a or b" indicates only a, only b, both a and b.

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings, wherein the same or corresponding elements may be denoted by the same reference numerals throughout and repeated descriptions thereof may be omitted.

It It will be understood that when a layer, a region, or a component is referred to as being "connected" to another layer, region, or component, it may be "directly connected" to the other layer, region, or component and/or may be "indirectly connected" to the other layer, region, or component with other layers, regions, or components interposed therebetween.

The x-axis, the y-axis and the z-axis are not limited to three axes of the rectangular coordinate system, and may be interpreted in a broader sense.

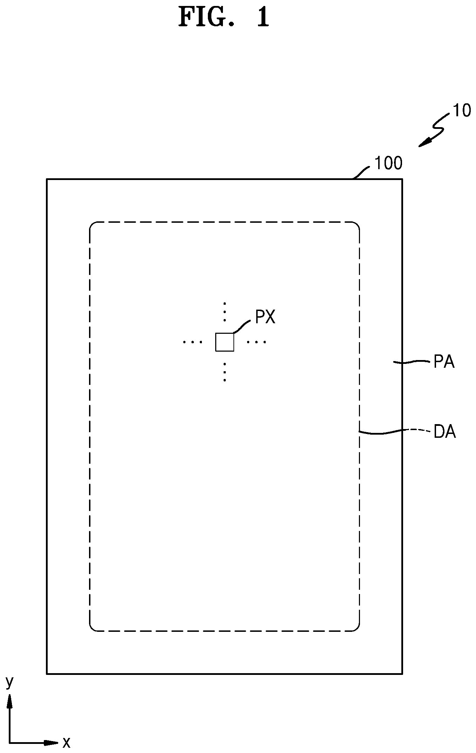

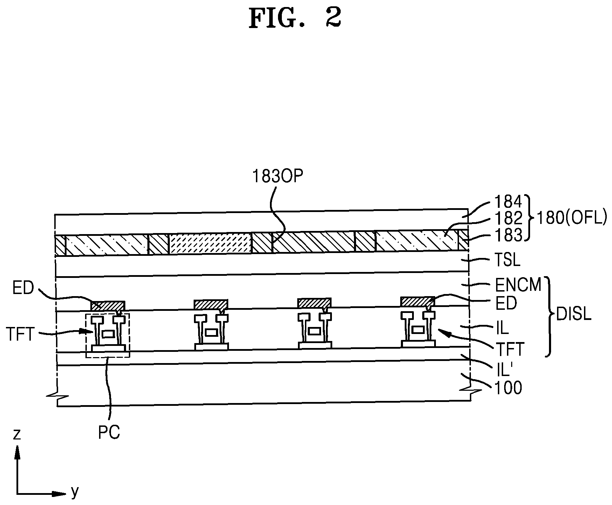

FIG. 1 is a plan view of a display apparatus, according to an embodiment. FIGS. 2 to 4 are cross-sectional views of a part of a display apparatus, according to an embodiment.

Referring to FIG. 1, in an embodiment, a display apparatus includes a display panel 10, and a cover window that protects the display panel 10 may be further located on the display panel 10. The display apparatus may include an organic light-emitting diode (OLED), a quantum dot light-emitting diode (QLED), or a quantum dot-organic light-emitting diode (QD-OLED) as a display device, and may be used in any of various electronic devices such as a smartphone, a foldable smartphone, or a tablet. However, embodiments of the disclosure are not necessarily limited thereto.

The display panel 10 includes a display area DA where an image is displayed and a peripheral area PA outside the display area DA. The peripheral area PA is a non-display area where no pixels PX are located. The display area DA may be entirely surrounded by the peripheral area PA. Various elements that constitute the display panel 10 are located on a substrate 100. Accordingly, the substrate 100 includes the display area DA and the peripheral area PA.

A plurality of pixels PX are disposed in the display area DA. Each pixel PX includes a display element. The display element is connected to a pixel circuit that drives the pixel PX. In an embodiment, the display element is an organic light-emitting diode OLED. Each pixel PX emits, for example, one of red, green, blue, or white light, through the organic light-emitting diode OLED.

In a plan view, the display area DA has a rectangular shape as shown in FIG. 1. In another embodiment, the display area DA has a polygonal shape, such as one of a triangular shape, a pentagonal shape, or a hexagonal shape, a circular shape, an elliptical shape, or an irregular shape.

The peripheral area PA is located around the display area DA and is an area where no image is displayed. In the peripheral area PA, various wirings that transmit electrical signals to the display area DA, outer circuits electrically connected to pixel circuits, and pads to which a printed circuit board or a driver integrated circuit (IC) chip is attached, are located.

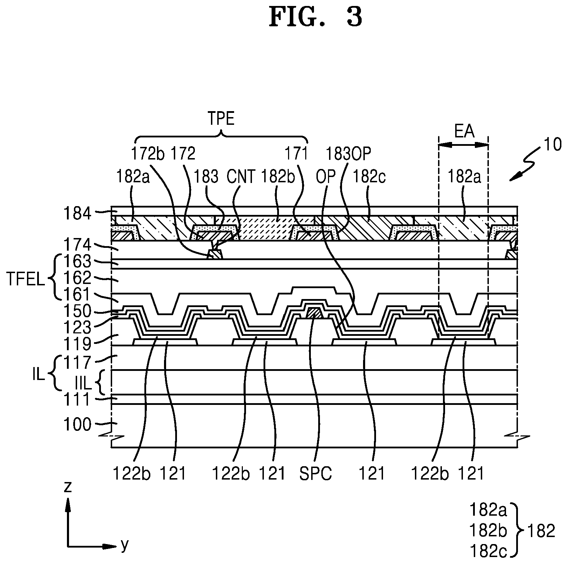

Referring to FIGS. 2 and 3, in an embodiment, the display panel 10 includes the substrate 100, a display layer DISL, a touchscreen layer TSL, and an optical functional layer OFL on the substrate 100.

The display layer DISL includes a pixel circuit PC that includes a thin-film transistor TFT, a light-emitting element ED as a display element, and a sealing member ENCM such as a thin-film encapsulation layer TFEL or a sealing substrate. Insulating layers IL and IL' are interposed between the substrate 100 and the display layer DISL and in the display layer DISL. For convenience of illustration, the pixel circuit PC is not shown in FIG. 3.

In an embodiment, the substrate 100 has a single-layer structure formed of a glass material. In an embodiment, the substrate 100 includes a polymer resin. The substrate 100 that includes a polymer resin has a multi-layer structure in which an organic layer that includes a polymer resin and an inorganic layer are stacked. The substrate 100 may be a rigid substrate, or a flexible substrate that is bendable, foldable, or rollable.

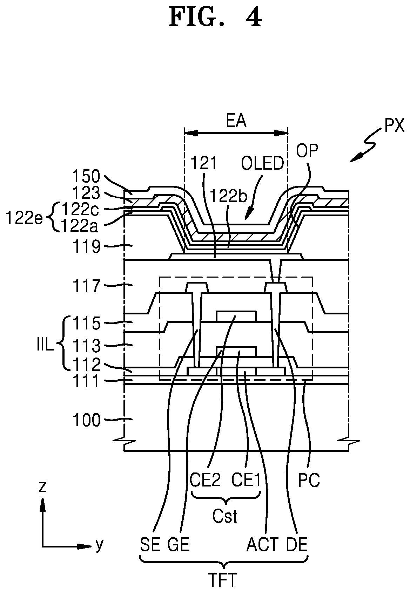

A buffer layer 111, an inorganic insulating layer IIL, and a planarization layer 117 are sequentially stacked on the substrate 100. The planarization layer 117 may include an organic material or an inorganic material, and may have a single layer or a multi-layer structure. The pixel circuit PC is located between the buffer layer 111 and the planarization layer 117. As shown in FIG. 4, the pixel circuit PC includes a thin-film transistor TFT and a capacitor Cst.

The thin-film transistor TFT includes a semiconductor layer ACT that includes at least one of amorphous silicon, polycrystalline silicon, or an organic semiconductor material such as an oxide semiconductor, a gate electrode GE, a source electrode SE, and a drain electrode DE. The capacitor Cst includes a lower electrode CE1 and an upper electrode CE2.

The semiconductor layer ACT is disposed on the buffer layer 111. A first insulating layer 112 is disposed on the buffer layer 111 and the semiconductor layer ACT, and the gate electrode GE is disposed the first insulating layer 112. A second insulating layer 113 is disposed on the first insulating layer 112 and the gate electrode GE, and the upper electrode CE2 of the capacitor Cst is disposed on the second insulating layer 113. The upper electrode CE2 overlaps the gate electrode GE that is located below the upper electrode CE2. The gate electrode GE and the upper electrode CE2 that overlap each other with the second insulating layer 113 therebetween constitute the capacitor Cst. The gate electrode GE is the lower electrode CE1 of the capacitor Cst. A third insulating layer 115 is disposed on the second insulating layer 113 and the capacitor Cst, and the source electrode SE and the drain electrode DE are disposed on the third insulating layer 115.

Each of the first insulating layer 112, the second insulating layer 113, and the third insulating layer 115 includes an inorganic material such as one of silicon oxide, silicon nitride, and/or silicon oxynitride. The first insulating layer 112, the second insulating layer 113, and the third insulating layer 115 may be collectively referred to as the inorganic insulating layer IIL.

The buffer layer 111 includes an inorganic material such as one of silicon oxide, silicon nitride, and/or silicon oxynitride, and is located between the thin-film transistor TFT and the substrate 100.

The planarization layer 117 is disposed on the third insulating layer 115 and the thin-film transistor TFT. The planarization layer 117 is formed of an organic insulating material such as at least one of acryl, benzocyclobutene (BCB), or hexamethyldisiloxane (HMDSO). The planarization layer 117 may include an inorganic insulating material such as at least one of silicon oxide (SiO_{X}), silicon nitride (SiN_{X}), silicon oxynitride (SiON), aluminum oxide (Al₂O₃), titanium oxide (TiO₂), tantalum oxide (Ta₂O₅), hafnium oxide (HfO₂), or zinc oxide (ZnO₂). When the planarization layer 117 is formed, a layer is formed and then chemical mechanical polishing is performed on a top surface of the layer that provides a flat top surface. The planarization layer 117 may have a single layer or a multi-layer structure.

An organic light-emitting diode OLED that is a display element is disposed on the planarization layer 117 as the light-emitting element ED. The organic light-emitting diode OLED includes a pixel electrode 121, a counter electrode 123, and an intermediate layer between the pixel electrode 121 and the counter electrode 123.

The pixel electrode 121 is disposed on the planarization layer 117, and the pixel electrode 121 contacts one of the source electrode SE or the drain electrode DE through a via hole in the planarization layer 117 to be electrically connected to the thin-film transistor TFT.

A pixel-defining film 119 is disposed on the planarization layer 117. The pixel-defining film 119 covers an edge of the pixel electrode 121, and includes an opening OP formed therein through which a part of the pixel electrode 121 is exposed. A size and a shape of an emission area EA of the organic light-emitting diode OLED is defined by the opening OP.

The pixel-defining film 119 may include a transparent insulating material or an opaque insulating material. In an embodiment, the pixel-defining film 119 includes an organic insulating material such as at least one of polyimide, polyamide, acrylic resin, benzocyclobutene, hexamethyldisiloxane (HMDSO), or phenolic resin. In an embodiment, the pixel-defining film 119 includes an inorganic insulating material such as one of silicon nitride or silicon oxide, or may include an organic insulating material and an inorganic insulating material.

In some embodiments, the pixel-defining film 119 includes a light-blocking material, and is black. The light-shielding material includes at least one of carbon black, carbon nanotubes, a resin or paste that includes a black dye, metal particles, such as nickel, aluminum, molybdenum, or an alloy thereof, metal oxide particles, such as chromium oxide, or metal nitride particles, such as chromium nitride. When the pixel-defining film 119 includes a light-blocking material, the reflection of external light from metal structures under the pixel-defining film 119 is reduced.

As shown in FIG. 3, a spacer SPC is further disposed on the pixel-defining film 119. In an embodiment, the spacer SPC and the pixel-defining film 119 include the same material. For example, the pixel-defining film 119 and the spacer SPC are formed together in a mask process that uses a halftone mask, and the spacer SPC has an island shape that protrudes a predetermined interval in a z direction from the pixel-defining film 119. In an embodiment, the spacer SPC and the pixel-defining film 119 include different materials. For example, the spacer SPC includes insulating patterns that have island shapes disposed on the pixel-defining film 119 and spaced apart from each other by a predetermined interval.

As shown in FIG. 4, the intermediate layer includes an emission layer 122b, and an organic functional layer 122e disposed over and/or under the emission layer 122b.

The emission layer 122b is located in the opening OP of the pixel-defining film 119 and corresponds to the pixel electrode 121. The emission layer 122b includes a high molecular weight material or a low molecular weight material, and emits one of red light, green light, blue light, or white light.

The organic functional layer 122e includes a first functional layer 122a and/or a second functional layer 122c. One of the first functional layer 122a or the second functional layer 122c can be omitted.

The first functional layer 122a is disposed under the emission layer 122b. The first functional layer 122a may have a single layer or a multi-layer structure that includes an organic material. In an embodiment, the first functional layer 122a is a hole transport layer (HTL) that has a single-layer structure. In an embodiment, the first functional layer 122a includes a hole injection layer (HIL) and a hole transport layer (HTL). The first functional layer 122a is integrally formed and corresponds to all of the organic light-emitting diodes OLED in the display area DA.

The second functional layer 122c is located on the emission layer 122b. The second functional layer 122c may have a single layer or a multi-layer structure that includes an organic material. The second functional layer 122c includes an electron transport layer (ETL) and/or an electron injection layer (EIL). The second functional layer 122c is integrally formed and corresponds to all of the organic light-emitting diodes OLED in the display area DA.

The counter electrode 123 is disposed on the emission layer 122b. An upper layer 150 that includes an organic material is disposed on the counter electrode 123.

In an embodiment, the intermediate layer includes two or more light-emitting units that are sequentially stacked between the pixel electrode 121 and the counter electrode 123, and a charge generation layer located between the two light-emitting units. When the intermediate layer includes a light-emitting unit and a charge generation layer, the organic light-emitting diode OLED is a tandem light-emitting element. Because the organic light-emitting diode OLED has a structure in which a plurality of light-emitting units are stacked, color purity and luminous efficiency are increased.

One light-emitting unit includes the emission layer 122b, and the first functional layer 122a and the second functional layer 122c under and over the emission layer 122b. The charge generation layer includes a negative charge generation layer and a positive charge generation layer. Due to the negative charge generation layer and the positive charge generation layer, the luminous efficiency of a tandem light-emitting element organic light-emitting diode OLED that includes a plurality of emission layers is further increased. The negative charge generation layer is an n-type charge generation layer. The negative charge generation layer supplies electrons. The negative charge generation layer includes a host and a dopant. The host includes an organic material. The dopant includes a metal. The positive charge generation layer is a p-type charge generation layer. The positive charge generation layer supplies holes. The positive charge generation layer includes a host and a dopant. The host includes an organic material. The dopant includes a metal.

The upper layer 150 protects the counter electrode 123 and increases light extraction efficiency. In an embodiment, the upper layer 150 includes LiF. In an embodiment, the upper layer 150 additionally includes an inorganic insulating material such as one of silicon oxide (SiOx) or silicon nitride (SiNx).

The display elements are covered by the thin-film encapsulation layer TFEL. In an embodiment, the thin-film encapsulation layer TFEL includes at least one inorganic encapsulation layer and at least one organic encapsulation layer. For example, the thin-film encapsulation layer TFEL includes first and second inorganic encapsulation layers 161 and 163 and an organic encapsulation layer 162 interposed between the first and second inorganic encapsulation layers 161 and 163.

The touchscreen layer TSL is disposed on the inorganic encapsulation layer 163. The touchscreen layer TSL obtains coordinate information from an external input, such as a touch event. The touchscreen layer TSL detects an external input by using a self-capacitive method or a mutual capacitive method. The touchscreen layer TSL includes touch electrodes TPE and wirings connected to the touch electrodes TPE. The touch electrodes TPE include first touch electrodes 171 and second touch electrodes 172. The first touch electrodes 171 are connected by connection electrodes located on the same layer. The second touch electrodes 172 are connected to connection electrodes 172b located on a different layer through a contact hole CNT in an insulating layer 174. The touch electrodes TPE are located to correspond to the pixel-defining film 119.

The optical functional layer OFL includes a filter layer 180 that includes a color filter 182, a light-blocking layer 183, and an overcoat layer 184. The light-blocking layer 183 covers the first touch electrodes 171 and the second touch electrodes 172. The light-blocking layer 183 is located to correspond to the pixel-defining film 119. The overcoat layer 184 includes an organic material such as a resin, and the organic material is transparent.

In the display panel 10 that uses the color filter 182 and the light-blocking layer 183 as the optical functional layer OFL, instead of a polarizer or a polarizing film, the luminous efficiency of the display element is increased, power consumption is reduced, and a luminance is increased, and thus, a lifetime of the display panel is increased. In addition, the same or higher luminance/lifetime can be ensured even with a smaller area than an existing emission area. Because a polarizer or a polarizing film is not used, a thickness of the display panel is reduced.

The color filter 182 includes a first color filter 182a through which only light of a first color is selectively transmitted, a second color filter 182b through which only light of a second color is selectively transmitted, and a third color filter 182c through which only light of a third color is selectively transmitted. The first color filter 182a, the second color filter 182b, and the third color filter 182c are located to correspond to the emission area EA of the pixel PX. The first color filter 182a, the second color filter 182b, and the third color filter 182c are located adjacent to each other. Each of the first color filter 182a, the second color filter 182b, and the third color filter 182c has an independent pattern structure. Each of the first color filter 182a, the second color filter 182b, and the third color filter 182c is located in an opening 183OP formed in the light-blocking layer 183. Each of the first color filter 182a, the second color filter 182b, and the third color filter 182c partially overlaps the pixel-defining film 119.

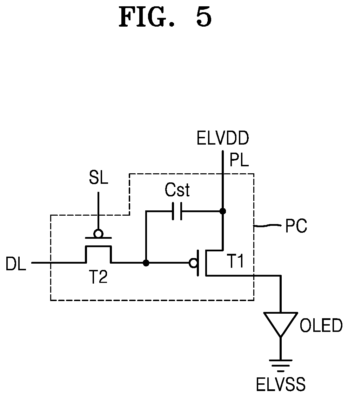

FIG. 5 i illustrates a display element in one sub-pixel of a display apparatus and a pixel circuit connected to the display element, according to an embodiment.

Referring to FIG. 5, in an embodiment, an organic light-emitting diode OLED that is a display element is connected to a pixel circuit PC. The pixel circuit PC includes a first thin-film transistor T1, a second thin-film transistor T2, and a storage capacitor Cst. For example, the organic light-emitting diode OLED emits one of red light, green light, or blue light, or emits one of red light, green light, blue light, or white light.

The second thin-film transistor T2 is a switching thin-film transistor and is connected to a scan line SL and a data line DL, and transmits a data voltage received from the data line DL to the first thin-film transistor T1 according to a switching voltage received from the scan line SL. The storage capacitor Cst is connected to the second thin-film transistor T2 and a driving voltage line PL, and stores a voltage that corresponds to a difference between a voltage received from the second thin-film transistor T2 and a first power supply voltage ELVDD received from the driving voltage line PL.

The first thin-film transistor T1 is a driving thin-film transistor and is connected to the driving voltage line PL and the storage capacitor Cst, and controls a driving current that flows to the organic light-emitting diode OLED from the driving voltage line PL according to a voltage value stored in the storage capacitor Cst. The organic light-emitting diode OLED emits light with a luminance due to the driving current. A first electrode, such as an anode, of the organic light-emitting diode OLED is connected to the pixel circuit PC, and a second electrode, such as a cathode, of the organic light-emitting diode OLED receives a second power supply voltage ELVSS.

Although FIG. 2 shows that the pixel circuit PC includes two thin-film transistors and one storage capacitor, in another embodiment, the number of thin-film transistors or the number of storage capacitors can change, according to a design of the pixel circuit PC.

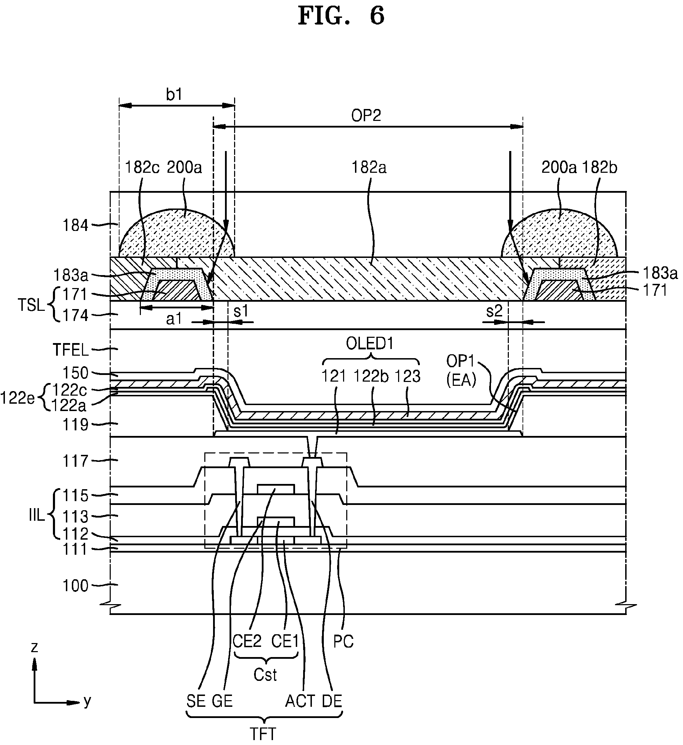

FIG. 6 is a cross-sectional view of a display apparatus, according to an embodiment. For example, FIG. 6 is an enlarged view of a part of FIG. 3.

Referring to FIG. 6, in an embodiment, as described with reference to FIG. 3, the pixel circuit PC is disposed on the substrate 100, and a first organic light-emitting diode OLED1 electrically connected to the pixel circuit PC is disposed on the pixel circuit PC. The first organic light-emitting diode OLED1 includes the pixel electrode 121, the emission layer 122b, and the counter electrode 123 located in a first opening OP1 of the pixel-defining film 119. The thin-film encapsulation layer TFEL is disposed on the first organic light-emitting diode OLED1, and the touchscreen layer TSL is disposed on the thin-film encapsulation layer TFEL. The touchscreen layer TSL includes the insulating layer 174 and the first touch electrode 171.

In an embodiment, a first light-blocking layer 183a is disposed on the first touch electrode 171. The first light-blocking layer 183a covers the first touch electrode 171. For example, the first touch electrode 171 is located in the first light-blocking layer 183a and directly contacts the first light-blocking layer 183a.

The first touch electrode 171 includes at least one of titanium (Ti), aluminum (Al), molybdenum (Mo), or copper (Cu). For example, the first touch electrode 171 may have a structure in which Ti and Al are stacked, a structure in which Al and Mo are stacked, or a structure in which Ti or Cu is stacked. However, embodiments of the disclosure are not necessarily limited thereto.

The first touch electrode 171 and the first light-blocking layer 183a overlap at least a part of the pixel-defining film 119. For example, the first light-blocking layer 183a includes a second opening OP2 that overlaps the first opening OP1 of the pixel-defining film 119. A size of the second opening OP2 in the first light-blocking layer 183a is greater than a size of the first opening OP1 in the pixel-defining film 119. Due to a size difference between the first opening OP1 of the pixel-defining film 119 and the second opening OP2 of the first light-blocking layer 183a, there is an area s1 or s2 adjacent to the first organic light-emitting diode OLED1where the first light-blocking layer 183a is not located on the pixel-defining film 119. When external light is incident on the area s1 or s2, the external light is not absorbed by the first light-blocking layer 183a and is reflected by the counter electrode 123 of the first organic light-emitting diode OLED1. When a reflectance of external light incident on the area s1 or s2 increases, the visibility of the display apparatus is adversely affected.

The first color filter 182a overlaps the second opening OP2 of the first light-blocking layer 183a. A first high-refractive index layer 200a is disposed on the first color filter 182. The first high-refractive index layer 200a overlaps the first light-blocking layer 183a. A length b1 of the first high-refractive index layer 200a in a first direction, such as a y direction or a -y direction, is greater than a length a1 of the first light-blocking layer 183a in the first direction, such as the y direction or the -y direction. The first high-refractive index layer 200a has a convex lens shape. In a cross-sectional view, the first high-refractive index layer 200a has a convex top surface.

The overcoat layer 184 is disposed on the first high-refractive index layer 200a. The overcoat layer 184 is continuously disposed over the substrate 100. A refractive index of the first high-refractive index layer 200a is greater than a refractive index of the overcoat layer 184.

Due to the convex lens shape of the first high-refractive index layer 200a provided on the first light-blocking layer 183a and the higher refractive index than the overcoat layer 184, external light incident on the area s1 or s2 is refracted from the convex top surface of the first high-refractive index layer 200a and is absorbed into the first light-blocking layer 183a. Because external light is refracted from the convex top surface of the first high-refractive index layer 200a and absorbed into the first light-blocking layer 183a, a reflectance of external light incident on the display apparatus is reduced and the visibility of the display apparatus is increased.

In addition, the first high-refractive index layer 200a may be formed over the second touch electrode 172.

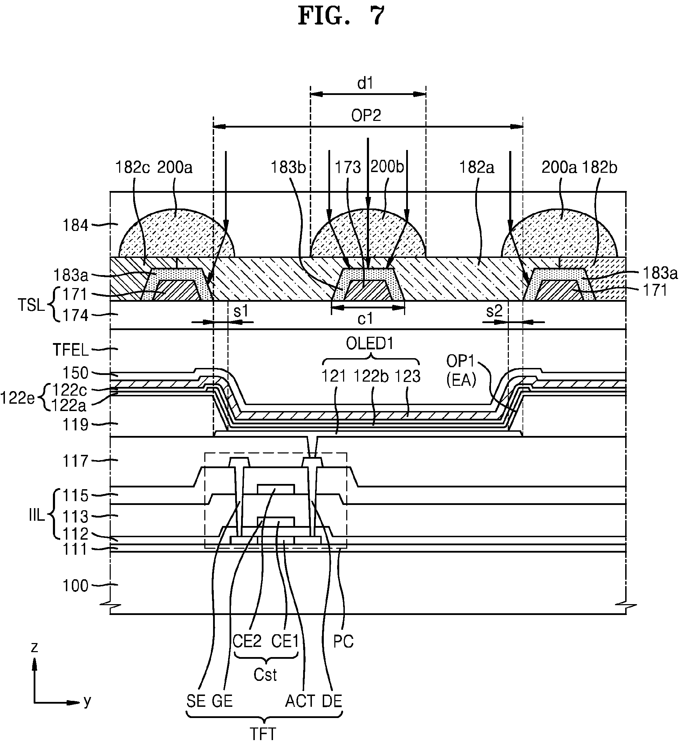

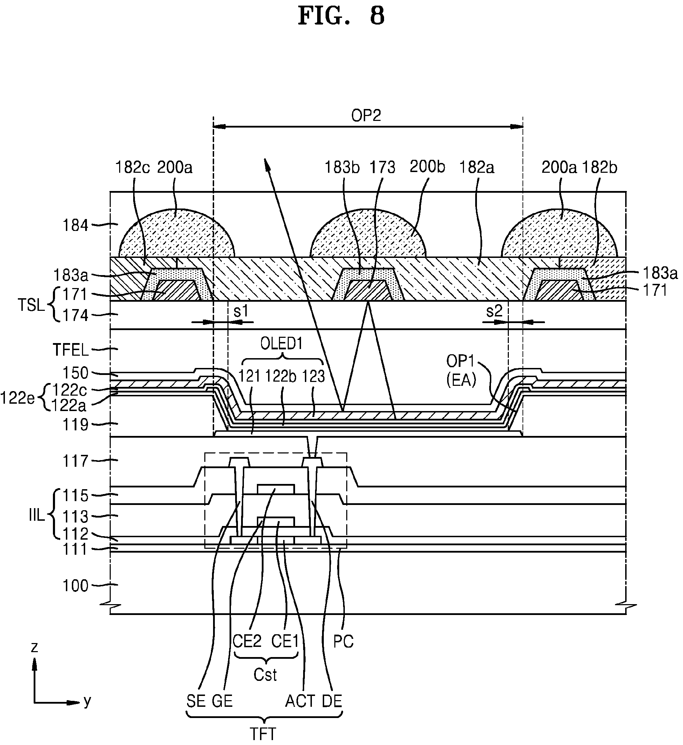

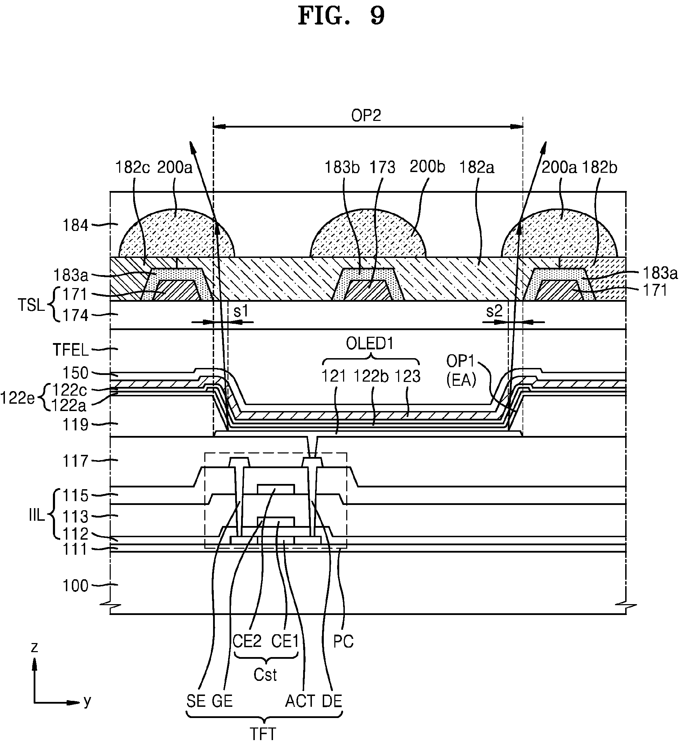

FIGS. 7 to 9 are cross-sectional views of a display apparatus, according to an embodiment. For example, FIGS. 7 to 9 schematically illustrate a path of incident external light and paths of light emitted from a first organic light-emitting diode, in a display apparatus according to an embodiment.

Referring to FIGS. 7 to 9, in an embodiment, a second light-blocking layer 183b, the first touch electrode 171, the first light-blocking layer 183a, and the first high-refractive index layer 200a are disposed on the first organic light-emitting diode OLED1 and overlap at least a part of the first organic light-emitting diode OLED1. For example, a length c1 of the second light-blocking layer 183b in the first direction, such as the y direction or the -y direction, is less than a length of the first opening OP1 of the pixel-defining film 119 in the first direction, such as the y direction or the -y direction. A metal light-blocking portion 173 is disposed in the second light-blocking layer 183b. For example, the second light-blocking layer 183b covers the metal light-blocking portion 173. The metal light-blocking portion 173 is a portion of the first touch electrode 171 and the second touch electrode 172, but unlike the first touch electrode 171 or the second touch electrode 172, the metal light-blocking portion 173 is grounded or used as a signal wiring. The metal light-blocking portion 173 is in direct contact with the second light-blocking layer 183b.

The metal light-blocking portion 173 includes at least one of titanium (Ti), aluminum (Al), molybdenum (Mo), or copper (Cu). For example, the metal light-blocking portion 173 may have a structure in which Ti and Al are stacked, a structure in which Al and Mo are stacked, or a structure in which Ti or Cu is stacked. However, embodiments of the disclosure are not necessarily limited thereto.

A second high-refractive index layer 200b is disposed over the second light-blocking layer 183b and overlaps the second light-blocking layer 183b. A length d1 of the second high-refractive index layer 200b in the first direction, such as the y direction or the -y direction, is greater than the length c1 of the second light-blocking layer 183b in the first direction, such as the y direction or the -y direction. The second high-refractive index layer 200b has a convex lens shape. In a cross-sectional view, the second high-refractive index layer 200b has a convex top surface. On the second high-refractive index layer 200b, the overcoat layer 184 is continuously located over the substrate 100. A refractive index of the second high-refractive index layer 200b is greater than a refractive index of the overcoat layer 184.

When the second light-blocking layer 183b and the second high-refractive index layer 200b provided in a convex lens shape and having a higher refractive index than the overcoat layer 184 are disposed on the first organic light-emitting diode OLED1, external light incident on the first organic light-emitting diode OLED1 is refracted from the convex top surface of the second high-refractive index layer 200b and absorbed into the second light-blocking layer 183b. Because the second high-refractive index layer 200b has a convex lens shape, a ratio of external light that is incident on the first organic light-emitting diode OLED1 and absorbed into the second light-blocking layer 183b increases. In addition, as described above, due to the first high-refractive index layer 200b on the first light-blocking layer 183b, external light incident on the area s1 or s2 is refracted from the convex top surface of the first high-refractive index layer 200a and is absorbed into the first light-blocking layer 183a. Accordingly, because external light incident on the display apparatus is refracted from the first high-refractive index layer 200a and the second high-refractive index layer 200b and is absorbed into the first light-blocking layer 183a and the second light-blocking layer 183b, a reflectance of external light incident on the display apparatus is reduced and the visibility of the display apparatus is increased.

Even when the second light-blocking layer 183b and the second high-refractive index layer 200b are disposed on the first organic light-emitting diode OLED1, the light extraction efficiency of light emitted from the first organic light-emitting diode OLED1 is not affected. For example, light emitted from the first organic light-emitting diode OLED1 under the second light-blocking layer 183b is reflected by the metal light-blocking portion 173 in the second light-blocking layer 183b and by the counter electrode 123 of the first organic light-emitting diode OLED1, and is emitted out.

Of light emitted from the first organic light-emitting diode OLED1, light emitted to the area s1 or s2 is refracted from the convex top surface of the first high-refractive index layer 200a and is emitted out from the first organic light-emitting diode OLED1. For example, light emitted from an edge portion of the pixel electrode 121 of the first organic light-emitting diode OLED1 is refracted from the convex top surface of the first high-refractive index layer 200a and is emitted in a wide range, thereby increasing the visibility of the display apparatus.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the spirit and scope as defined by the following claims.

## Claims

1. A display apparatus, comprising:
a substrate;
a pixel-defining film disposed on the substrate and comprising a first opening formed therein;
a first organic light-emitting diode that includes a pixel electrode, an emission layer, and a counter electrode disposed in the first opening;
a first light-blocking layer disposed on the pixel-defining film and that includes a second opening formed therein, wherein the second opening overlaps the first opening;
a first color filter that overlaps the second opening; and
a first high-refractive index layer that overlaps the first light-blocking layer and has a convex lens shape.

2. The display apparatus of claim 1, further comprising a first touch electrode disposed on the first organic light-emitting diode,
wherein the first light-blocking layer overlaps the first touch electrode.

3. The display apparatus of claim 2, wherein the first touch electrode comprises at least one of titanium (Ti), aluminum (Al), molybdenum (Mo), or copper (Cu).

4. The display apparatus of claim 1, further comprising an overcoat layer disposed on the first high-refractive index layer.

5. The display apparatus of claim 4, wherein a refractive index of the first high-refractive index layer is greater than a refractive index of the overcoat layer.

6. The display apparatus of claim 1, wherein a size of the second opening is greater than a size of the first opening.

7. The display apparatus of claim 1, wherein a length of the first high-refractive index layer in a first direction is greater than a length of the first light-blocking layer in the first direction.

8. The display apparatus of claim 1, further comprising a thin-film encapsulation layer disposed on the first organic light-emitting diode.

9. The display apparatus of claim 8, further comprising a touchscreen layer disposed on the thin-film encapsulation layer.

10. The display apparatus of claim 1, further comprising a pixel circuit disposed on the substrate and electrically connected to the first organic light-emitting diode.

11. The display apparatus of claim 1, further comprising a second light-blocking layer that overlaps at least a part of the first organic light-emitting diode.

12. The display apparatus of claim 11, further comprising a second high-refractive index layer that overlaps the second light-blocking layer and has a convex lens shape.

13. The display apparatus of claim 11, wherein a length of the second light-blocking layer in a first direction is less than a length of the first opening in the first direction.

14. The display apparatus of claim 11, further comprising a second touch electrode disposed in the second light-blocking layer.

15. The display apparatus of claim 12, wherein a length of the second high-refractive index layer in a first direction is greater than a length of the second light-blocking layer in the first direction.

16. The display apparatus of claim 14, wherein the second touch electrode comprises at least one of titanium (Ti), aluminum (Al), molybdenum (Mo), or copper (Cu).

17. A display apparatus, comprising:
a first sub-pixel and a second sub-pixel disposed in a display area;
a light-blocking layer that overlaps an emission area of the first sub-pixel and includes an opening portion;
a first color filter layer that overlaps the emission area of the first sub-pixel;
and
a high-refractive index layer disposed on the first color filter layer and that overlaps the light-blocking layer and has a convex lens shape.

18. The display apparatus of claim 17, further comprising a first touch electrode,
wherein the first touch electrode does not overlap the emission area of the first sub-pixel and directly contacts the light-blocking layer.

19. The display apparatus of claim 18, further comprising a metal light-blocking portion,
wherein the metal light-blocking portion overlaps the emission area of the first sub-pixel and directly contacts the light-blocking layer.

20. The display apparatus of claim 19, wherein the first touch electrode transmits a touch signal, and the metal light-blocking portion is grounded.
